# EUROPEAN PATENT APPLICATION

(11) **EP 2 627 004 A1**
(43) Date of publication of application: **14.08.2013**
(21) Application number: 13250016.6
(22) Date of filing: 08.02.2013
(51) Int. Cl.: H03K 17/96, B29C 45/14

(54) **Device module**

(30) Priority: 10.02.2012 JP 2012027109
(71) Applicant: Hosiden Corporation, Yao-shi, Osaka 581-0071 (JP)
(72) Inventor: Isoda, Takeshi, Yao-shi, Osaka 581-0071 (JP); Shinoda, Koji, Yao-shi, Osaka 581-0071 (JP)
(74) Representative: Beresford, Keith Denis Lewis

(57) **Abstract**

The invention provides a device module adapted for easy external connection of a device. The device module includes a flexible sheet 100, a touch sensor 400 provided on the sheet 100, a reinforcing part 600 provided on the sheet 100, a connecting part 500 connected to the touch sensor 400, and a plastic part 300 provided on the sheet 100. The touch sensor 400, the reinforcing part 600, and the connecting part 500 are embedded in the plastic part 300. The plastic part 300 includes a first opening 320 that exposes a portion of the reinforcing part 600 and a portion of the connecting part 500 on the opposite side thereof from the sheet 100 to the outside of the plastic part 300.

## Description

The invention relates to device modules.

Japanese Unexamined Patent Publication No. 2009-238661 discloses a device module including a transparent flexible sheet that is touchable by an object to be detected such as a finger, capacitive electrodes printed on the sheet and adapted to detect a touch of the object, and a plastic part provided on the sheet.

The electrodes printed on the sheet are covered with the plastic part. It is therefore difficult to connect the electrodes to the outside.

The invention is made in view of the above circumstances. The invention provides a device module adapted for easy external connection of a device.

The invention provides a device module including a sheet, a device being a sensor, an electronic component, or a circuit board; a reinforcing part provided on the sheet; a connecting part connected to the device; and a plastic part provided on the sheet. The device, the reinforcing part, and the connecting part are embedded in the plastic part. The plastic part includes a first opening that exposes at least a portion of the reinforcing part and a portion of the connecting part on an opposite side thereof from the sheet to the outside of the plastic part.

In this aspect of the invention, a portion of the connecting part is exposed from the first opening of the plastic part. Therefore, the device can be easily connected to the outside by connecting the exposed part of the connecting part to the outside. Moreover, the first opening is provided in the plastic part so as to expose a part of the reinforcing part on the opposite side thereof from the sheet to the outside of the plastic part. In other words, the reinforcing part is embedded below the first opening of the plastic part. It is therefore possible to compensate reduction in strength of the plastic part due to its reduced thickness by providing the first opening.

The connecting part may have flexibility. The reinforcing part may be engaged with or fixed to the connecting part. In this aspect of the invention, the reinforcing part, embedded in the plastic part so as to be partially exposed from the first opening, is engaged with or fixed to the connecting part. The exposed part of the connecting part from the first opening is less likely to move when embedding the device, the reinforcing part, and the connecting part in the plastic part by insert molding. It is thus possible to improve the operating efficiency in embedding the device, the reinforcing part, and the connecting part into the plastic part.

The device may be provided on the sheet. Alternatively, the device embedded in the plastic part may be in spaced relation to the sheet.

The device module may further include a spacer. The spacer and the device may be embedded in the plastic part, with the spacer disposed on the sheet and the device disposed on the spacer.

All edges of the spacer on the side of the sheet may be in curved form. In this aspect of the invention, the outer shape of the spacer hardly causes irregularities on the flexible sheet when forming the plastic part. Further, the spacer may be made of material in the same group as that of the material for the sheet or made of an elastic material. In this aspect of the invention, the outer shape of the spacer hardly causes irregularities on the flexible sheet when forming the plastic part.

The device module may further include a shield provided at a boundary on the reinforcing part between the plastic part and the first opening. In this aspect of the invention, when forming the plastic part, plastic material is less likely to flow into a recess provided in a convex portion to form the first opening of a mold.

The plastic part may further include a second opening provided on an opposite side of the device from the sheet. Alternatively, the plastic part may further include a second opening provided on an opposite side of the device from the spacer. In these aspects of the invention, the plastic part provided with the second opening can be fabricated with reduced amount of plastic material, leading to reduced cost of the device module. Moreover, as the device, or the spacer and the device are embedded below the second opening of the plastic part, it is possible to compensate reduction in strength of the plastic part due to reduced thickness of the plastic part by providing the second opening.

At least one of the sheet and the plastic part may have translucency. Alternatively, at least one of the sheet, the plastic part, or the spacer has translucency. If both the sheet and the plastic part have translucency, a display portion such as an LCD (liquid crystal display) or an illuminating part such as an LED (light emitting diode) or an EL (electro luminescence) device may be disposed on a face of the plastic part that is opposite from the face facing the sheet. These aspects of the invention also improve the transmittance of the plastic part if the plastic part has the second opening.

All edges of the reinforcing part on the side of the sheet may be in curved form. In this aspect of the invention, the outer shape of the reinforcing part hardly causes irregularities on the flexible sheet when forming the plastic part.

The reinforcing part and the spacer may be integrated with each other. This aspect of the invention can reduce the number of components for the device module.

The connecting part may further include an external connecting portion provided on a portion of the connecting part that is exposed from the first opening.

If the sheet has translucency, the device module may further include an ornamental layer interposed between the sheet and the plastic part.

A first manufacturing method of the device module of the invention is as follows. First, the device is prepared (the device may be, for example, a sensor, an electronic component, or a circuit board), to which the connecting part is connected. Also prepared is the reinforcing part engaged with or fixed to the connecting part. The device and the reinforcing part are fixed to the sheet, which is then fixed to a first mold. The first mold is combined with a second mold, thereby bringing a convex portion of the second mold into abutment with the reinforcing part. Plastic is poured into the first and second molds, and the first and second molds are removed later.

Instead of fixing the device to the sheet, it is possible to fix the spacer to the sheet and the device to the spacer.

A second manufacturing method of the device module of the invention is as follows. First, prepared is the device (a sensor, an electronic component, or a circuit board), to which the connecting part is connected. Also prepared is the reinforcing part engaged with or fixed to the connecting part. The reinforcing part is fixed to the sheet, which is fixed to a first mold, while the device is then fixed to a second mold. The first and second molds are then combined with each other, thereby bringing a convex portion of the second mold into abutment with the reinforcing part. Plastic is poured into the first and second molds, and the first and second molds are removed later.

The second mold may have a movable part that can be nested and function as the convex portion. In this case, the movable part may be brought into contact with the reinforcing part after combining the first and second molds.

The invention will now be described by way of example only and without limitation by reference to the drawings, in which:
Fig. 1A is a front, top, and right side schematic perspective view of a device module in accordance with the First embodiment of the invention.
Fig. 1B is a rear, top and left side schematic perspective view of the device module in accordance with the First embodiment of the invention.
Fig. 2A is a schematic partial end view of the device module in accordance with the First embodiment of the invention taken along line 2A-2A in Fig. 1B.
Fig. 2B is a schematic partial sectional view of the device module in accordance with the First embodiment of the invention taken along line 2A-2A in Fig. 1B as attached to a circuit board of electronic equipment.
Fig. 3 is a schematic end view of the device module in accordance with the Second embodiment of the invention.
Fig. 4 is a schematic end view of the device module in accordance with the Third embodiment of the invention.
Fig. 5 is a schematic front, bottom, and right side perspective view of a spacer of the device module.
Fig. 6 is a schematic partial end view of a device module in accordance with the Fourth embodiment of the invention.
Fig. 7A is a schematic partial end view of a first modification of the device module in accordance with the First embodiment of the invention.
Fig. 7B is a schematic partial end view of a first modification of the device module in accordance with the Second embodiment of the invention.
Fig. 7C is a schematic partial end view of a first modification of the device module in accordance with the Third embodiment of the invention.
Fig. 8 is a schematic partial end view showing a second modification of the device module in accordance with the Third embodiment of the invention.
Fig. 9A is a schematic partial end view of a second modification of the device module in accordance with First embodiment of the invention.
Fig. 9B is a schematic partial sectional view of the modified device module of Fig. 9A as mounted on electronic equipment.
Fig. 10A is a schematic partial end view of a modification of the device module in accordance with the First to Third embodiments and the above modifications.
Fig. 10B is a schematic partial end view of another modification of the device module in accordance with the First to Third embodiments and the above modifications.

In the description which follows, relative spatial terms such as "upper", "lower", "top", "bottom", "left", "right", "front", "rear", "back", "below", etc., are used for the convenience of the skilled reader and refer to the orientation of the device module and its constituent parts as depicted in the drawings. No limitation is intended by use of these terms, either in use of the invention, during its manufacture, shipment, custody, or sale, or during assembly of its constituent parts or when incorporated into or combined with other apparatus.

The First to Fourth embodiments of the invention will be described below by way of example.

### First embodiment

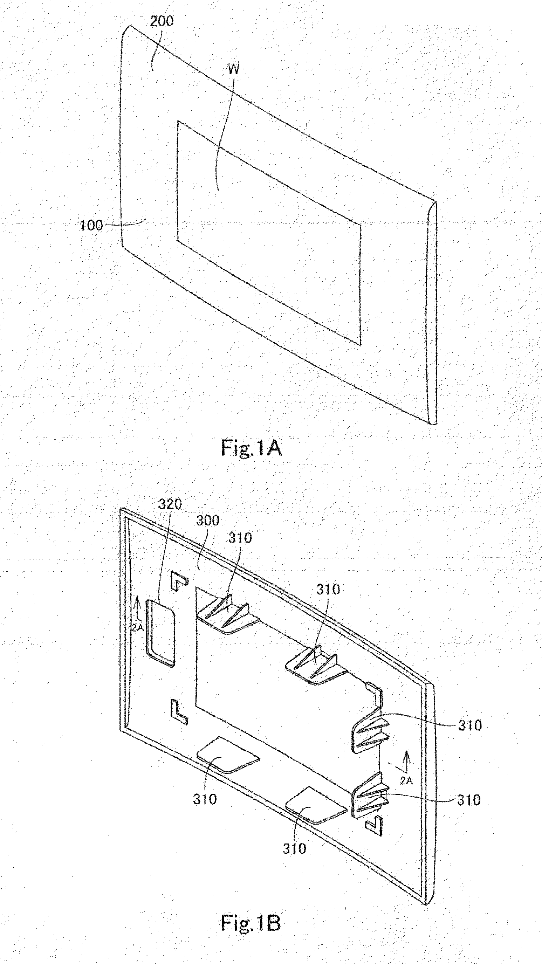

First, a device module in accordance with the First embodiment will be described with reference to Fig. 1A to Fig. 2B. The device module shown in Fig. 1A to Fig. 2B is a touch sensing device. The device module includes a sheet 100, an ornamental layer 200, a plastic part 300, a touch sensor 400 (corresponding to the device in the claims), a connecting part 500, and a reinforcing part 600. These constituents of the device module will be described below in detail.

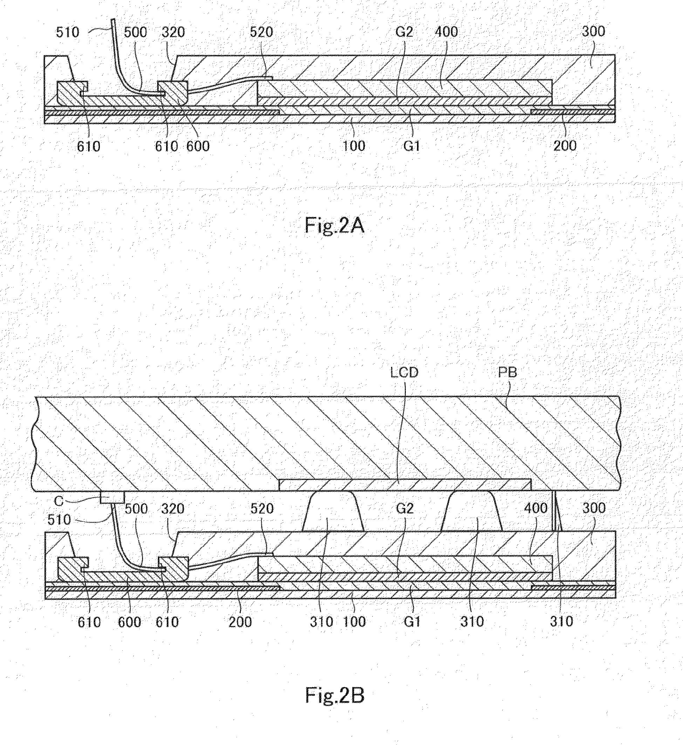

The sheet 100 is a substantially rectangular flexible film of optically transparent resin such as PET (polyethylene terephthalate) and acrylic resin. The sheet 100 has an outer face and an inner face (the lower and upper faces in Fig. 2A and Fig. 2B). As shown in Fig. 1A and Fig. 1 B, the periphery of the inner face of the sheet 100 is subjected to ornamental printing (e.g. painted in black) in a frame shape to form the ornamental layer 200. The ornamental layer 200 defines a rectangular transparent window W in the center of the sheet 100 as shown in Fig. 1A. The transparent window W on the outer face of the sheet 100 serves as a touch sensing surface. As shown in Fig. 2A and Fig. 2B, a bonding layer G1 is applied to the inner face of the sheet 100 and the ornamental layer 200.

The touch sensor 400 is a capacitive touch panel of substantially rectangular shape and in rigid or flexible and optically transparent sheet form to detect a detection object such as a finger that touches the touch sensing surface. The touch sensor 400 is fixed to the inner face of the transparent window W of the sheet 100 and an inner periphery of the ornamental layer 200 via the bonding layer G1 and an adhesive layer G2 (that is, the touch sensor 400 is laid on the transparent window W of the sheet 100 and the inner periphery of the ornamental layer 200). The touch sensor 400 extends substantially parallel to the outer face of the sheet 100, maintaining a constant distance between the touch sensor 400 and the outer face of the sheet 100 (the touch sensing surface).

If the touch sensor 400 is in a rigid transparent sheet form, it may have any one of the configurations (1) to (3) indicated below. If the touch sensor 400 is in a flexible transparent sheet form, it may have any one of the configurations (4) to (6) indicated below.
1) The touch sensor 400 includes a first transparent substrate having first and second faces in its thickness direction, a plurality of first transparent electrodes provided on the first face of the first transparent substrate, and a plurality of second transparent electrodes provided on the second face of the first transparent substrate.
2) The touch sensor 400 includes a first transparent substrate, a plurality of first transparent electrodes provided on the first transparent substrate, an insulating layer provided on the first transparent substrate so as to cover the first transparent electrodes, and a plurality of second transparent electrodes provided on the insulating layer.
3) The touch sensor 400 includes a first transparent substrate having a first face, a second transparent substrate having a first face opposed to the first face of the first transparent substrate, a plurality of first transparent electrodes provided on the first face of the first transparent substrate, and a plurality of second transparent electrodes provided on the first face of the second transparent substrate.
4) The touch sensor 400 includes a flexible insulating first transparent film having first and second faces in its thickness direction, a plurality of first transparent electrodes provided on the first face of the first transparent film, and a plurality of second transparent electrodes provided on the second face of the first transparent film.
5) The touch sensor 400 includes a flexible insulating first transparent film, a plurality of first transparent electrodes provided on the first transparent film, a flexible insulating second transparent film provided on the first transparent film so as to cover the first transparent electrodes, and a plurality of second transparent electrodes provided on the second transparent film.
6) The touch sensor 400 includes a flexible insulating first transparent film having a first face, a flexible insulating second transparent film having a first face opposed to the first face of the first transparent film, a plurality of first transparent electrodes provided on the first face of the first transparent film, and a plurality of second transparent electrodes provided on the first face of the second transparent film.

It should be appreciated that the sheet 100 may be used as the first transparent film. In the case where the sheet 100 has no flexibility, it may be used as the first transparent substrate.

The connecting part 500 has flexibility. Specifically, the connecting part 500 is a flexible printed circuit board (PCB) (see Fig. 2A and Fig. 2B) or a flexible insulating transparent film. The connecting part 500 has lengthwise opposite ends, namely a first end 510 and a second end 520. If the connecting part 500 is a flexible PCB, the second end 520 is connected to at least one of the first and second transparent substrates or the first and second transparent films of the touch sensor 400, and the flexible PCB has a plurality of conducting lines connected to the first and second transparent electrodes. If the connecting part 500 is a flexible insulating transparent film, the second end 520 is connected to at least one of the first and second transparent substrates or the first and second transparent films of the touch sensor 400, and the transparent film has a plurality of conducting lines connected to the first and second transparent electrodes.

The reinforcing part 600 is a block having a substantially U-shaped cross section. It may be made of insulating resin, elastomer, adhesive such as hot-melt adhesive and OCA (Optically Clear Adhesive), a double-faced tape, or metal such as Steel Use Stainless (SUS). The reinforcing part 600 is fixed to the ornamental layer 200 on the sheet 100 with the bonding layer G1 as shown in Figs. 2A and 2B. At least one of the longitudinal ends of the reinforcing part 600 has a receiving hole (not shown) to receive the connecting part 500. An engaging piece 610 projects inward from each longitudinal distal end of the reinforcing part 600. One of the engaging pieces 610 is engaged with the connecting part 500 passed through the receiving hole. The longitudinal ends and the widthwise ends of the reinforcing part 600 have edges in curved form on the side of the sheet 100. The curved edges prevent the outer shape of the reinforcing part 600 appearing as irregularities on the outer face of the flexible sheet 100 when forming the plastic part 300.

The plastic part 300 is a substantially rectangular part made of insulating thermosoftening or thermosetting plastic. The plastic part 300 is provided on the inner face of the sheet 100 and the ornamental layer 200. The sheet 100 is generally in intimate contact with or integrated into the plastic part 300 and has hardened (i.e. has lost its flexibility). The plastic part 300 maintains the touch sensing surface of the flexible sheet 100 in a flat state. Embedded in the plastic part 300 are the touch sensor 400, about half of the connecting part 500 on the second end 520 side, and the longitudinal and widthwise ends of the reinforcing part 600 (that is, the periphery of the reinforcing part 600). The plastic part 300 has a substantially rectangular central area, corresponding to the transparent window W of the sheet 100, and a peripheral area around the central area. The back face of the plastic part 300 is provided with a plurality of ribbed parts 310 surrounding the central area in a lateral U-shape arrangement as shown in Fig. 1B. The ribbed parts 310 can be fixed to a housing or a circuit board PB (see Fig. 2B) of electronic equipment. The plastic part 300 (with its ribbed parts 310 fixed to the housing or the circuit board PB of the electronic equipment), the ornamental layer 200, and the sheet 100 constitute the ornamental panel of the electronic equipment. A rectangular first opening 320 is formed in an end (the left end in Fig. 2A and Fig. 2B) of the peripheral area of the plastic part 300. The opening 320 exposes the central area inside the periphery of the reinforcing part 600 and the about half of the connecting part 500 on the first end 510 side.

The device module configured as described above may be manufactured in the following steps. First, the sheet 100 is prepared. The periphery of the inner face of the sheet 100 is subjected to ornamental printing such as gravure printing to form the ornamental layer 200. After that, the bonding layer G1 is applied or formed in any other process on the inner face of the sheet 100 and the ornamental layer 200.

Also prepared are the touch sensor 400, with the connecting part 500 connected thereto, and the reinforcing part 600. The first end 510 of the connecting part 500 is inserted into the receiving hole of the reinforcing part 600, so that the connecting part 500 is engaged with one of the engaging pieces 610 of the reinforcing part 600. Then, the adhesive layer G2 is applied or formed in any other process on the touch sensor 400. After that, the touch sensor 400 is placed on and along the inner face of the sheet 100 and the ornamental layer 200. At the same time, the reinforcing part 600 is mounted at a predetermined position (the position corresponding to the first opening 320 of the plastic part 300) on the ornamental layer 200. As a result, the touch sensor 400 is fixed to the inner face of the sheet 100 and the ornamental layer 200 with the bonding layer G1 and the adhesive layer G2. The engaging part 600 is also fixed to the ornamental layer 200 with the bonding layer G1.

After that, the sheet 100 with the ornamental layer 200, the touch sensor 400, the connecting part 500, and the reinforcing part 600 are placed in a first mold (not shown), onto which the outer face of the sheet 100 is fixed. Then, the first mold is combined with a second mold (not shown). Then, a convex portion of the second mold comes into contact with the central portion of the reinforcing part 600. Also, the about half of the connecting part 500 on the first end 510 side is received in a recess formed in the convex portion, or alternatively, the convex portion comes into contact with the about half of the connecting part 500 on the first end 510 side. In this state, thermosoftening or thermosetting plastic is poured into the first and second molds to insert mold the touch sensor 400, the about half of the connecting part 500 on the second end 520 side, and the periphery of the reinforcing part 600 in the thermosoftening or thermosetting plastic. The hardened thermosoftening or thermosetting plastic forms the plastic part 300. Thus embedded by insert molding in the plastic part 300 are: the touch sensor 400 in contact with the sheet 100, the about half of the connecting part 500 on the second end 520 side as connected to the touch sensor 400, and the periphery of the reinforcing part 600. This insert molding process also forms the first opening 320 of the plastic part 300, conforming to the convex portion of the second mold, and the plurality of ribbed parts 310 of the plastic part 300 from the thermosoftening or thermosetting plastic entered in a plurality of recesses of the second mold. The sheet 100 is brought into close contact with or integrated with the plastic part 300, and it hardens. After that, the first and second molds are removed. Then, the central portion of the reinforcing part 600 and the about half of the connecting part 500 on the first end 510 side are exposed from the first opening 320 of the plastic part 300 to the outside of the plastic part 300.

The device module thus manufactured may be installed in electronic equipment in the following manner. First, the first end 510 of the connecting part 500 is connected to the connector C on the circuit board PB of the electronic equipment as shown in Fig. 2B. After that, the device module is fixed to the circuit board PB of the electronic equipment with a screw or other means as shown in Fig. 2B. Simultaneously, the ribbed parts 310 are engaged with the housing or the circuit board PB of the electronic equipment. The device module is thus mounted on the electronic equipment. The circuit board PB of the electronic equipment may or may not have an LCD (Liquid Crystal Display) mounted thereon. In the former case, when the device module is fixed to the housing or the circuit board PB, the LCD is located on the back side of the central area of the plastic part 300. That is, the LCD is visually recognizable from the outside through the central area of the plastic part 300, the touch sensor 400, and the transparent window W of the sheet 100.

The device module of this embodiment has many technical features. Firstly, since the first end 510 of the connecting part 500 is exposed from the first opening 320 of the plastic part 300, the first end 510 can be easily connected to the circuit board PB. In other words, the touch sensor 400 can be easily connected to the circuit board PB (i.e. to the outside). Secondly, the connecting part 500, although flexible, is engaged with the reinforcing part 600 disposed in the first opening 320 of the plastic part 300. As there is no need to fix the position of the connecting part 500 in the mold during the insert molding, it is possible to improve the efficiency of the insert molding process.

Generally speaking, in the case where a sheet has flexibility when molding the plastic part on the sheet, providing an opening in the plastic part tends to cause the sheet to have a sink mark at a portion exposed from the opening, to cause light leaks from the opening of the plastic part, and/or to cause the plastic part to decrease in strength due to its reduced thickness. However, in the present device module, the first opening 320 for leading out the connecting part 500 is formed in the plastic part 300 so as to expose the central area of the reinforcing part 600 fixed to the sheet 100. In other words, the reinforcing part 600 in contact with the sheet 100 is embedded below the first opening 320 of the plastic part 300. Therefore, the sheet 100 is less likely to have a sink mark when molding the plastic part 300, and the plastic part 300 is less likely to suffer from light leaks from its first opening 320 or decreased strength due to its reduced thickness.

Further, the touch sensor 400 as disposed on the inner face of the sheet 100 is embedded in the plastic part 300 by insert molding, reducing the distance between the outer face (the touch sensing face) of the sheet 100 and the touch sensor 400. It is therefore possible to improve the sensitivity of the touch sensor 400. Still further, the touch sensor 400 embedded in the plastic part 300 can be disposed at a large distance from the LCD that may be disposed on the back side of the touch sensor 400. It is therefore possible to omit a shield between the LCD and the touch sensor 400 for shielding noise from the LCD.

### Second embodiment

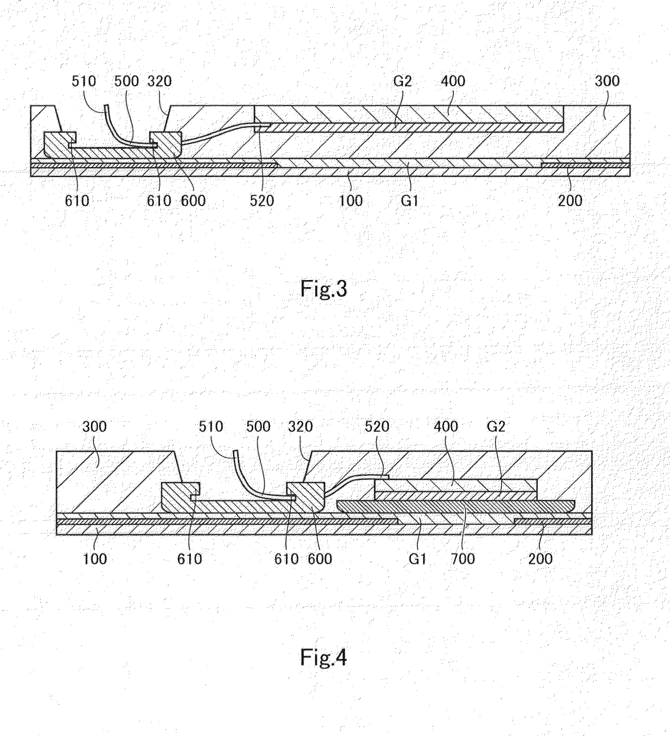

Next, a device module in accordance with the Second embodiment will be described with reference to Fig. 3. The device module shown in Fig. 3 has substantially the same configuration as that of the First embodiment, except that the touch sensor 400 is embedded in the plastic part 300 in spaced relation to the sheet 100. This difference will be described below in detail, but redundant descriptions will be omitted. Constituents of the present device module are given the same reference numerals as those for the First embodiment because only the embedding position of the touch sensor 400 is changed as described above.

The touch sensor 400 has the same configuration as that of the First embodiment. The touch sensor 400 is embedded in the central area of the plastic part 300 such that the touch sensor 400 extends substantially parallel to the outer face (lower face in the figure) of the sheet 100, and such that the back face (upper face in the figure) of the touch sensor 400 is flush with the back face (upper face in the figure) of the plastic part 300. That is, there is a clearance between the touch sensor 400 and the sheet 100, and there is a constant distance between the touch sensor 400 and the outer face (the touch sensing surface) of the sheet 100. The adhesive layer G2 is attached to a front face (lower face in the figure) of the touch sensor 400. The adhesive layer G2 improves adhesiveness between the touch sensor 400 and the plastic part 300.

The device module configured as described above may be manufactured in the following steps. First, as in the First embodiment, the sheet 100 formed with the ornamental layer 200 is prepared. After that, a bonding layer G1 is applied or formed in any other process on the inner face of the sheet 100 and the ornamental layer 200.

Also prepared are the touch sensor 400, with a connecting part 500 connected thereto, and a reinforcing part 600. After that, a first end 510 of the connecting part 500 is inserted into a receiving hole of the reinforcing part 600. This insertion causes the connecting part 500 to be engaged with one of the engaging pieces 610 of the reinforcing part 600. After that, the reinforcing part 600 is mounted at a predetermined position (the position corresponding to a first opening 320 of the plastic part 300) on the ornamental layer 200. As a result, the reinforcing part 600 is fixed to the ornamental layer 200 with the bonding layer G1. After that, the adhesive layer G2 is applied or formed in any other process on the touch sensor 400.

After that, the sheet 100 with the ornamental layer 200, the connecting part 500, and the reinforcing part 600 are placed in a first mold (not shown), onto which the outer face of the sheet 100 is fixed. The touch sensor 400 is fixed to a second mold (not shown). The first mold is then combined with the second mold. Then, a convex portion of the second mold comes into contact with the central portion of the reinforcing part 600. Also, an about half of the connecting part 500 on the first end 510 side is received in a recess formed in the convex portion, or alternatively, the convex portion comes into contact with the about half of the connecting part 500 on the first end 510 side. In this state, thermosoftening or thermosetting plastic is poured into the first and second molds to insert mold the touch sensor 400, the about half of the connecting part 500 on the second end 520 side, and the periphery of the reinforcing part 600 in the thermosoftening or thermosetting plastic. The hardened thermosoftening or thermosetting plastic forms the plastic part 300. Thus embedded by insert molding in the plastic part 300 are: the touch sensor 400 in spaced relation to and substantially in parallel to the sheet 100, the about half of the connecting part 500 on the second end 520 side as connected to the touch sensor 400, and the periphery of the reinforcing part 600. This insert molding process also forms the first opening 320 of the plastic part 300, conforming to the convex portion of the second mold, and a plurality of ribbed parts of the plastic part 300 from the thermosoftening or thermosetting plastic entered in a plurality of recesses of the second mold. The sheet 100 is brought into close contact with or integrated with the plastic part 300, and it hardens. After that, the first and second molds are removed. Then, the central portion of the reinforcing part 600 and the about half of the connecting part 500 on the first end 510 side are exposed from the first opening 320 of the plastic part 300 to the outside of the plastic part 300.

The device module thus manufactured may be installed in electronic equipment in a similar manner to the First embodiment. The device module produces effects similar to those of the First embodiment. Moreover, the touch sensor 400 is embedded in the plastic part 300 in spaced relation to the sheet 100. It is therefore easy to dispose the touch sensor 400 at an appropriate position to provide the best sensitivity.

### Third embodiment

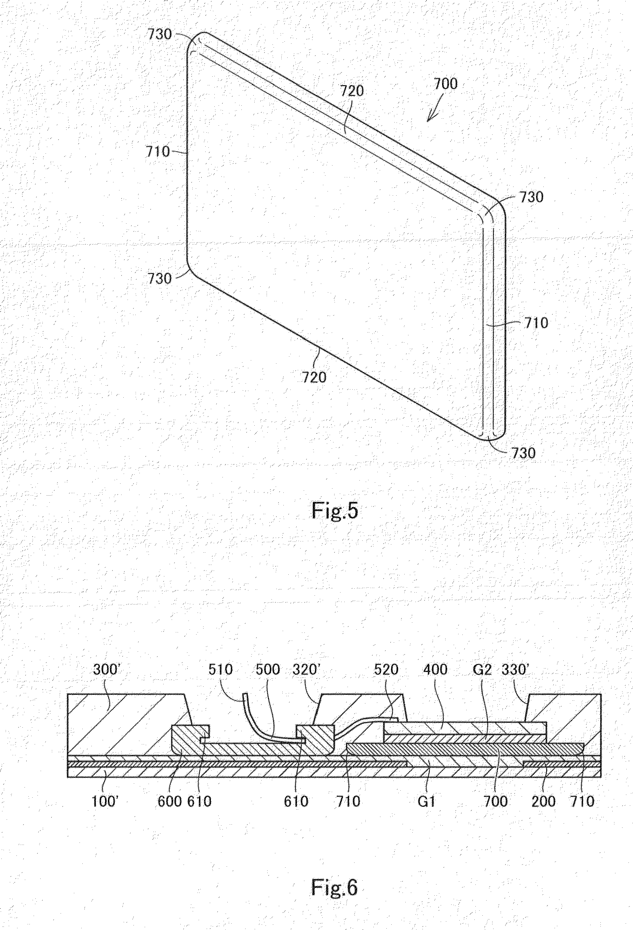

Next, a device module in accordance with the Third embodiment will be described with reference to Fig. 4 and Fig. 5. The device module shown in Fig. 4 has substantially the same configuration as that of the First embodiment, except that a spacer 700 is additionally provided between a sheet 100 and a touch sensor 400. Only this difference will be described below in detail, and redundant description will be omitted. Constituents of the present device module are given the same reference numerals as those for the First embodiment because the difference is the additionally provided spacer 700 only.

The spacer 700 is a substantially rectangular transparent plate formed of insulating plastic, elastomer, adhesive such as hot-melt adhesive and OCA (Optically Clear Adhesive), or a double-faced adhesive tape. The spacer 700 has a larger length than the touch sensor 400 and has a larger width than the touch sensor 400. The spacer 700 is fixed on a transparent window W of the sheet 100 and an inner periphery of an ornamental layer 200 with a bonding layer G1 (that is, the spacer 700 is disposed on and along the transparent window W of the sheet 100 and the inner periphery of the ornamental layer 200).

As shown in Fig. 5, the spacer 700 has curved (rounded) edges on the side of the sheet 100, namely edges 710 at opposite longitudinal ends, edges 720 at opposite widthwise ends, and four corner edges 730. All of the edges 710, 720, and 730 are curved to prevent the outer shape of the spacer 700 from appearing as irregularities on the outer face of the sheet 100 having flexibility when forming the plastic part 300.

The touch sensor 400 is fixed to the spacer 700 with an adhesive layer G2.The spacer 700 is disposed on the sheet 100 and the touch sensor 400 is disposed on the spacer 700 (the sheet 100, the spacer 700, and the touch sensor 400 are stacked in this order). The touch sensor 400 and the spacer 700 in the stacked state are embedded in the plastic part 300.

The device module configured as described above may be manufactured in the following steps. First, as in the First embodiment, the sheet 100 formed with an ornamental layer 200 is prepared. After that, a bonding layer G1 is applied or formed in any other process on the inner face of the sheet 100 and the ornamental layer 200. The spacer 700 is also prepared. The spacer 700 is mounted on the inner face of the sheet 100 and the ornamental layer 200 so as to be fixed to the inner face of the sheet 100 and the ornamental layer 200 with the bonding layer G1.

Also prepared are the touch sensor 400, with a second end 520 of a connecting part 500 connected thereto, and a reinforcing part 600. After that, a first end 510 of the connecting part 500 is inserted into a receiving hole of the reinforcing part 600. This insertion causes the connecting part 500 to be engaged with one of the engaging pieces 610 of the reinforcing part 600. After that, an adhesive layer G2 is applied or formed in any other process on the touch sensor 400. The touch sensor 400 is then mounted on the spacer 700, and the reinforcing part 600 is mounted at a predetermined position (the position corresponding to a first opening 320 of the plastic part 300) on the ornamental layer 200. As a result, the touch sensor 400 is fixed to the spacer 700 with the adhesive layer G2. The reinforcing part 600 is fixed to the ornamental layer 200 with the bonding layer G1.

After that, the sheet 100 with the ornamental layer 200, the spacer 700, the touch sensor 400, the connecting part 500, and the reinforcing part 600 are placed in a first mold (not shown), onto which the outer face of the sheet 100 is fixed. Then, the first mold is combined with a second mold (not shown). Then, a convex portion of the second mold comes into contact with the central portion of the reinforcing part 600. Also, an about half of the connecting part 500 on the first end 510 side is received in a recess formed in the convex portion, or alternatively, the convex portion comes into contact with the about half of the connecting part 500 on the first end 510 side. In this state, thermosoftening or thermosetting plastic is poured into the first and second molds to insert mold the spacer 700, the touch sensor 400, the about half of the connecting part 500 on the second end 520 side, and the periphery of the reinforcing part 600 in the thermosoftening or thermosetting plastic. The hardened thermosoftening or thermosetting plastic forms the plastic part 300. Thus embedded by insert molding in the plastic part 300 are: the spacer 700 and the touch sensor 400 disposed thereon, the about half of the connecting part 500 on the second end 520 side as connected to the touch sensor 400, and the periphery of the reinforcing part 600. This insert molding process also forms the first opening 320 of the plastic part 300, conforming to the convex portion of the second mold, and a plurality of ribbed parts of the plastic part 300 from the thermosoftening or thermosetting plastic entered in a plurality of recesses of the second mold. The sheet 100 is brought into close contact with or integrated with the plastic part 300, and it hardens. After that, the first and second molds are removed. Then, the central portion of the reinforcing part 600 and the about half of the connecting part 500 on the first end 510 side are exposed from the opening 320 of the plastic part 300 to the outside of the plastic part 300.

The device module thus manufactured may be installed in electronic equipment in a similar manner to the First embodiment. The device module produces effects similar to those in the First embodiment. Moreover, the spacer 700 is interposed between the touch sensor 400 and the sheet 100. The thickness of the spacer 700 can be determined so as to optimize the sensitivity of the touch sensor 400. It is therefore easy to dispose the touch sensor 400 at an appropriate position to provide the best sensitivity.

### Fourth embodiment

Next, a device module in accordance with the Fourth embodiment will be described with reference to Fig. 6. The device module shown in Fig. 6 has the substantially same configuration as that of the Third embodiment, except that a plastic part 300' has an additional opening, namely a second opening 330'. Only this difference will be described below in detail, and redundant descriptions will be omitted. A symbol _'_ is added to the reference numerals of the sheet and their subcomponents and the plastic part to distinguish them from those of the Third embodiment.

The second opening 330' of the plastic part 300' is formed on the back side of the touch sensor 400 (on the opposite side from a spacer 700) so as to expose a central portion of the touch sensor 400.

The spacer 700 as disposed on the sheet 100' is embedded in the plastic part 300'. The touch sensor 400 is disposed on the spacer 700 and its periphery is embedded in the plastic part 300'.

The device module configured as described above may be manufactured in the following steps. The manufacturing steps are the same as those in the Third embodiment until the spacer 700 and the touch sensor 400 are stacked in this order on the inner face of the sheet 100' and the ornamental layer 200, and the reinforcing part 600 is fixed to the ornamental layer 200.

The next step is to place the sheet 100' with the ornamental layer 200, the spacer 700, the touch sensor 400, the connecting part 500, and the reinforcing part 600 in a first mold (not shown) and fix the outer face of the sheet 100' to the first mold. The first mold is then combined with a second mold (not shown). Then, a first convex portion of the second mold comes into contact with the central portion of the reinforcing part 600, and a second convex portion of the second mold comes into contact with the central portion of the touch sensor 400. Also, an about half of the connecting part 500 on the first end 510 side is received in a recess formed in the first convex portion, or alternatively, the first convex portion comes into contact with the about half of the connecting part 500 on the first end 510 side. In this state, thermosoftening or thermosetting plastic is poured into the first and second molds to insert mold the spacer 700, the periphery of the touch sensor 400, the about half of the connecting part 500 on the second end 520 side, and the periphery of the reinforcing part 600 in the thermosoftening or thermosetting plastic. The hardened thermosoftening or thermosetting plastic forms the plastic part 300'. The spacer 700 and the periphery of the touch sensor 400 are thus embedded in the plastic part 300', with the spacer 700 disposed on the sheet 100' and the touch sensor 400 disposed on the spacer 700. Also embedded in the plastic part 300' are: the about half of the connecting part 500 on the second end 520 side as connected to the touch sensor 400, and the periphery of the reinforcing part 600. This insert molding process also forms a first opening 320' of the plastic part 300' conforming to the first convex portion of the second mold, the second opening 330' of the plastic part 300' conforming to the second convex portion of the second mold, and a plurality of ribbed parts of the plastic part 300' from the thermosoftening or thermosetting plastic entered in a plurality of recesses of the second mold. The sheet 100' is brought into close contact with or integrated with the plastic part 300', and it hardens. After that, the first and second molds are removed. Then, the central portion of the reinforcing part 600 and the about half of the connecting part 500 on the first end 510 side are exposed from the first opening 320' to the outside of the plastic part 300', and the central part of the touch sensor 400 is exposed from the second opening 330'.

The device module thus manufactured may be installed in electronic equipment in a similar manner to the Third embodiment. The device module produces effects similar to those in the Third embodiment. Moreover, since the second opening 330' of the plastic part 300' is formed on the back side of the touch sensor 400, it is possible to reduce the amount of plastic for the plastic part 300' and improve the transmittance of the portion of the touch sensor 400 corresponding to the second opening 330'.

Generally speaking, in the case where a sheet has flexibility when molding the plastic part, providing an opening in the plastic part tends to cause the sheet to have a sink mark at a portion exposed from the opening, to cause light leaks from the opening of the plastic part, and/or to cause the plastic part to decrease in strength due to its reduced thickness. However, in the present device module, the second opening 330' is formed in the plastic part 300' so as to expose the central portion of the touch sensor 400. In other words, the spacer 700 as disposed on the sheet 100 and the touch sensor 400 as disposed on the spacer 700 are embedded below the second opening 300' of the plastic part 300'. Therefore, the sheet 100 is less likely to have a sink mark when molding the plastic part 300', and the plastic part 300' is less likely to suffer from light leaks from its second opening 300' or decreased strength due to its reduced thickness.

The device module of the invention is not limited to the embodiments and may be modified within the scope of claims. Specific modifications will be described below.

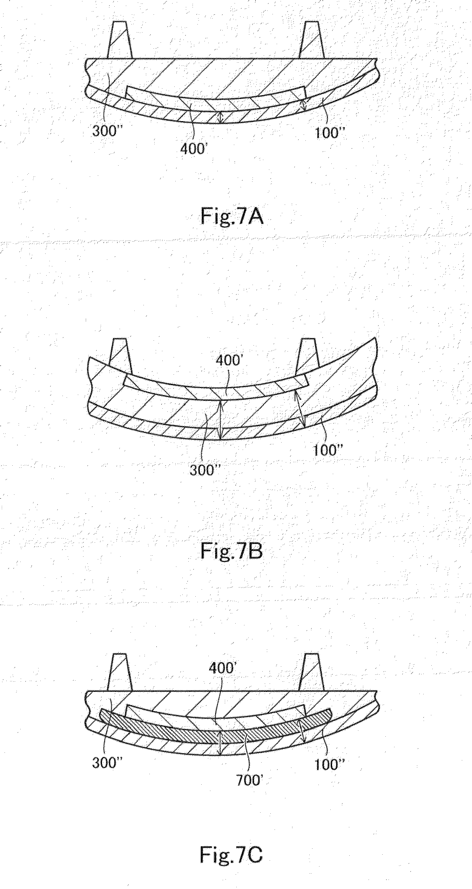

In the First to Fourth embodiments, the plastic part maintains the touch sensing surface of the sheet in a flat state. Fig. 7A to Fig. 7C each illustrate a modified plastic part 300", which is curved so as to maintain a touch sensing surface of a sheet 100" in a curved form. In any of these illustrated modifications, the plastic part 300" may have a touch sensor 400' embedded therein in curved form such that the distance between the touch sensor 400' and the touch sensing surface of the sheet 100" is generally constant.

More specifically, the touch sensor 400' shown in Fig. 7A is disposed on an inner face of the sheet 100" and embedded in the plastic part 300" in curved form such that the distance between the touch sensor 400' and the touch sensing surface of the sheet 100" is generally constant. The touch sensor 400' shown in Fig. 7B is embedded in the plastic part 300" in curved form and in spaced relation to the sheet 100" such that the distance between the touch sensor 400' and the touch sensing surface of the sheet 100" is generally constant. The touch sensor 400' shown in Fig. 7C is disposed on the spacer 700' and is embedded in curved form together with the spacer 700' in the plastic part 300" such that the distance between the touch sensor 400' and the touch sensing surface of the sheet 100" is generally constant. The spacer 700' is in curved form conforming to the touch sensing surface. In any of these modified device modules, the touch sensor is embedded in the plastic part in curved form such that the distance between the touch sensor and the touch sensing surface (that is, the outer face of the sheet) is generally constant. It is therefore possible to keep the sensitivity of the touch sensor generally constant in the whole area. In other words, it is possible to prevent variations in sensitivity of the touch sensor between different areas (for example, between a central area and a peripheral area) due to varying distances from the touch sensor to the touch sensing surface (the outer face of the sheet). Fig. 7A to Fig. 7C do not show the ornamental layer, the connecting part, the bonding layer, the adhesive layer, the reinforcing part, or the first opening of the plastic part, but any of these components with the same configurations as those in the First to Fourth embodiments may be included in any of these modified device module.

The above-mentioned device is a touch sensor in the form of a capacitive touch panel. However, the device of the invention may be any type of sensor, any type of electronic component, or any type of circuit board. In other words, the device module of the invention may be configured such that, in place of a sensor, an electronic component or a circuit board is embedded in the plastic part. The sensor may be of any type including touch panels of a type other than the capacitive type (for example, a touch panel of resistive film-type, optical-type, ultrasonic-type, or in-cell type), a touch switch (for example, a touch switch of capacitive, resistive film-type, optical-type, ultrasonic-type, or in-cell type), or a sensor other than the touch panel and the touch switch (for example, a magnetic sensor, an optical sensor, or a light-dark sensor) can be used. In the touch panel and the touch switch (touch sensor), the electrode may be provided on the sheet according to any well-known printing method. The touch panel and the touch switch may be opaque. The touch input surface of each of the touch panel and the touch switch is not limited to the outer surface of the sheet. For example, the outer surface of a panel provided on the side of the outer surface of the sheet may be used as the touch input surface. Examples of the electronic component include active components (for example, semiconductor) and passive components (for example, a resistor, a capacitor, and a coil).

The plastic part 300 of the First to Third embodiments each includes the ribbed parts 310 and the first opening 320. The plastic part 300' of the Fourth embodiment includes the ribbed parts 310', the first opening 320', and the second opening 330'. However, the plastic part of the invention may be of any configuration adapted to be embedded with the device, the reinforcing part, and the connecting part and to have a first opening that exposes at least a portion of the reinforcing part and a portion of the connecting part on an opposite side thereof from the sheet to the outside of the plastic part. It is therefore possible to omit the second opening.

The second opening described above is provided in the plastic part to expose the central portion of the touch sensor 400. The second opening of the invention may be provided at any part of the plastic part that is on the opposite side of the device from the sheet or the spacer. For example, if the device in contact with or in spaced relation to the sheet is embedded in the plastic part, the plastic part may have a second opening to expose a part of the device on the side opposite from the sheet. Alternatively, the second opening of the plastic part may be provided on the opposite side of the device from the sheet or the spacer so as not to expose a part of the device on the side opposite from the sheet. That is, the second opening may be a recess not to allow the exposure of a part of the device. In any of the above cases, the provision of the second opening in the plastic part is advantageous because of the reduced amount of plastic required. Also, the provision of the second opening in the plastic part is advantageous in the case where both the sheet and the plastic part have translucency. Since the portion of the plastic part having the second opening is thin-walled, the plastic part has a better transmittance at the thin-walled portion. The plastic part shown in Fig. 7A to 7C may have any of the above-mentioned second openings.

The plastic part of the invention may be modified like the plastic part 300" as shown in Fig. 7A and Fig. 7C, including a sheet contacting face in curved form and a back face in flat form on the opposite side from the sheet contacting face. Fig. 7B illustrates an alternative plastic part 300" including a sheet contacting face in curved form and a back face in curved form on the opposite side from the sheet contact face. The plastic part 300" shown in Fig. 7A and Fig. 7C and the plastic part in the above embodiment may be modified to include a back face in curved form. The plastic part 300" shown in Fig. 7B may also be modified to have a back face in flat form. The plastic part may be formed without the ribbed parts in the case where the plastic part is stably disposed to oppose the circuit board PB by fixing the device module to the circuit board PB of the electronic equipment with a screw or by other means. By "curved" used herein is meant any non-flat surfaces including spherical. The sheet contact face and/or the back face of the plastic part may be in any curved form.

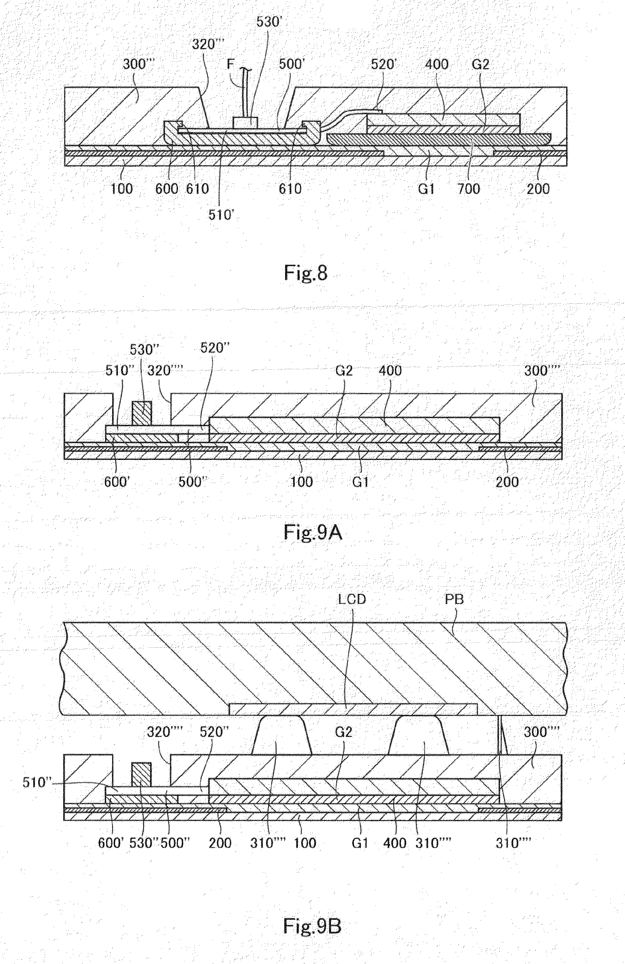

The connecting part described above may be a flexible printed circuit board or a flexible sheet as described above. However, the connecting part of the invention may be modified in any manner as long as it is adapted to be embedded in the plastic part as connected to the device and to be partially exposed from the first opening of the plastic part to the outside of the plastic part. For example, the connecting part may be a rigid circuit board. Further, the connecting part may have a conducting line provided on the sheet and connected to the device. The connecting part may also be a lead wire. Fig. 8 illustrates a modified device module, wherein a connecting part 500' includes an external connecting portion 530' provided on a first end 510' exposed from a first opening 320"' of a plastic part 300"'. The external connecting portion 530' may be a B-to-B (board-to-board) connector, an FPC (flexible printed circuit) connector, or the like. Figs. 9A and 9B illustrate another modified device module, wherein a connecting part 500" includes an external connecting portion 530" provided on a first end 510". The external connecting portion 530" may be a B-to-B connector, an FPC connector, or the like. In the connecting part 500', an area of the first end 510' that is provided with the external connecting portion 530' is exposed from the first opening 320"' of the plastic part 300"'. The external connecting portion 530' may be connected to a flexible circuit board F. In the connecting part 500", an area of the first end 510" that is provided with the external connecting portion 530" is exposed from a first opening 320"" of a plastic part 300"". The reinforcing part 600' is fixed to the face facing the sheet of the first end 510" of the connecting part 500", and it is embedded in the plastic part 300"" together with the first end 510". The reinforcing part 600' is in contact with or fixed to the sheet 100 via the ornamental layer 200. The external connecting portion in either of the modified connecting part may be a header pin, a contact, or an electrode.

The reinforcing part of the First to Fourth embodiments is a substantially U-shaped block. However, the reinforcing part may be modified in any manner as long as it is provided on the sheet and is partially embedded in the plastic part. For example, the reinforcing part may not be engaged with the connecting part (refer to Fig. 9A and Fig. 9B). The reinforcing part may have at least one part to engage with the connecting part, such as an engaging hole, an engaging recess, and an engaging piece. Fig. 8 illustrates a modification in which the first end 510' of the connecting part 500' is engaged with the pair of engaging pieces 610 of the reinforcing part 600. The engaging part may be visually transparent. It is possible to appropriately select the outer shape and/or material of the reinforcing part, which hardly causes irregularities of the sheet having flexibility due to its outer shape when molding the plastic part. For example, the reinforcing part may have all of the edges on the side of the sheet in curved forms as in the First to Fourth embodiments or may be made of material in the same group as that of the material for the sheet (for example, plastic material in the same group as that of the material for the sheet: e.g. polycarbonate (PC) or polymethylmethacrylate (PMMA) corresponding to the sheet 100 of the above embodiments). The reinforcing part may also be made of an elastic material.

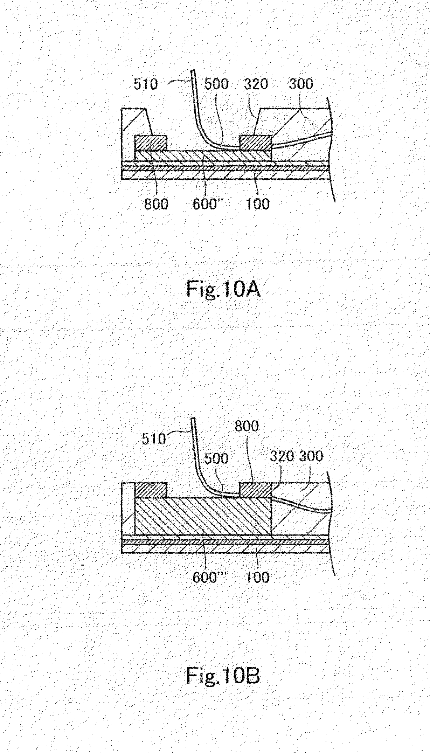

Further, the reinforcing part may not be engaged with or fixed to the connecting part. For example, the reinforcing part may be a generally rectangular block provided on the sheet 100, which may be configured like a reinforcing part 600" of a modified device module as shown in Fig. 10A or a reinforcing part 600"' of a modified device module as shown in Fig. 10B. A shield 800 may be provided on the reinforcing part 600"/600"'. The shield 800 may be a ring-like elastic body made of elastomer or other material disposed along a boundary between the plastic part 300 and the first opening 320. More particularly, the shield 800 is configured such that its outer circumference is embedded on the reinforcing part 600"/600"' and in the circumferential wall of the first opening 320, while its inner circumference is disposed on the reinforcing part 600"/600"' and on the bottom of the first opening 320. The modified device modules shown in Figs. 10A and 10B may be configured to include components (other than the reinforcing part and the shield) in accordance with the above described embodiments and other modifications. In the modified device modules shown in Figs. 10A and 10B, as the shield 800 is provided along the boundary on the reinforcing part 600"/600"', when forming the plastic part 300, a convex portion of a mold for molding the plastic part 300 elastically contacts with the shield 800. Therefore, plastic material is less likely to flow into a recess provided in the convex portion of a mold. It should be noted that the aforementioned convex portion of the mold is used to form the first opening 320, and the recess is provided in the convex portion.

The spacer may be any member to be embedded in the plastic part so as to be interposed between the sheet and the device. For example, in the case where the sheet is optically opaque, the spacer may be made of metal such as SUS. The spacer may have all of the edges on the side of the sheet in curved form. However, the spacer is not limited to this. It is possible to appropriately select the outer shape and/or material of the spacer, which hardly causes irregularities on a flexible sheet when molding of the plastic part. For example, all of the edges of the spacer on the side of the sheet may be in curved form as in the First to Fourth embodiments. Further, the spacer may be made of material in the same group as that of the material for the sheet (for example, plastic material in the same group as that of the material for the sheet: e.g. polycarbonate (PC) or polymethylmethacrylate (PMMA) corresponding to the sheet 100 of the above embodiments). The spacer may also be made of an elastic material. In the case where the spacer is of a circular disc shape, the ring-shaped edge of the outer periphery of the spacer may be in curved form on the side of the sheet. In the case where the spacer is a polygonal plate, all edges on the side of the sheet may be in curved form. Further, the spacer may be integrated with the reinforcing part.

The sheet may be visually transparent and flexible as described above, but it is not limited to this. The sheet may be configured to be translucent and flexible, or optically opaque and flexible, or translucent and nonflexible, or optically opaque and nonflexible. Further, the sheet may be made of a material that will not harden (will not lose its flexibility) after molding the plastic part. The ornamental layer may be provided on the inner face of the sheet as described above or may be omitted. Further, the ornamental layer may be formed entirely on the inner face of the sheet to make the sheet opaque. The bonding layer G1 and/or the adhesive layer G2 may be omitted.

The device modules of the First to Fourth embodiments may be manufactured in the methods as described above or in any other manner including the steps of the first or second manufacturing methods described below. A first manufacturing method of the device module of the invention is as follows. First, prepared is the device (a sensor, an electronic component, or a circuit board), to which the connecting part is connected. Also prepared is the reinforcing part engaged with or fixed to the connecting part. The device and the reinforcing part are fixed to the sheet, which is fixed to a first mold. The first mold is combined with a second mold, thereby bringing a convex portion of the second mold into abutment with the reinforcing part. Plastic is poured into the first and second molds, and the first and second molds are removed later. In this manufacturing method, instead of fixing the device to the sheet, it is possible to fix the spacer to the sheet and the device to the spacer. The second mold may have a movable part that can be nested and function as the convex portion. In this case, the movable part may be brought into contact with the reinforcing part after combining the first and second molds.

A second manufacturing method of the device module of the invention is as follows. First prepared is the device (a sensor, an electronic component, or a circuit board), to which the connecting part is connected. Also prepared is the reinforcing part engaged with or fixed to the connecting part. The reinforcing part is fixed to the sheet, which is fixed to a first mold, while the device is fixed to a second mold. The first and second molds are then combined with each other, thereby bringing a convex portion of the second mold into abutment with the reinforcing part. Plastic is poured into the first and second molds, and the first and second molds are removed later. The second mold may have a movable part that can be nested and function as the convex portion. In this case, the movable part may be brought into contact with the reinforcing part after combining the first and second molds. The sheet prepared as described above may or may not have the ornamental layer thereon.

Also, when the convex portion of the second mold is brought into contact with the reinforcing part, the convex portion may be brought into contact with a portion of the connecting part. Alternatively, when the convex portion of the second mold is brought into contact with the engaging part, a portion of the connecting part may be received in a recess provided in the convex portion of the second mold. In either of these cases, the said portion of the connecting part is exposed from the first opening of the plastic part.

It should be appreciated that the above-described preferred embodiments and modifications are described by way of example only. The material, shape, dimensions, number, arrangement, and other features of each constituent element of the device module may be modified as long as they provide the same functions. At least one of the sheet, the plastic part, and the spacer may have translucency. The circuit board PB may be provided with, in place of the display such as an LCD, an illumination part such as a LED (light emitting diode) or an EL (electroluminescence) device.

### Reference Signs List

100: sheet
100': sheet
100": sheet
200: ornamental layer
300: plastic part
   310: ribbed part
   320: first opening
300': plastic part
   320': first opening
300": plastic part
300"': plastic part
   320"': first opening
400: touch sensor (device)
500: connecting part
   510: first end
   520: second end
500': connecting part
   510': first end
   520': second end
   530': external connecting portion
500": connecting part
   510": first end
   520": second end
   530": external connecting portion
600: reinforcing part
600': reinforcing part
   610': engaging piece
700: spacer
   710: edge (edge on the side of the sheet)
   720: edge (edge on the side of the sheet)
   730: edge (edge on the side of the sheet)
800: shield

The disclosure of this application also includes the following clause.

In the device module according to any of claims 5 to 7, at least one of the sheet 100, the plastic part 300, and the spacer 700 has translucency.

## Claims

1. A device module comprising:
a sheet (100);
a device (400) being a sensor, an electronic component, or a circuit board;
a reinforcing part (600) provided on the sheet;
a connecting part (500) connected to the device; and
a plastic part (300) provided on the sheet, wherein
the device, the reinforcing part, and the connecting part are embedded in the plastic part, and
the plastic part includes a first opening (320) that exposes at least a portion of the reinforcing part and a portion of the connecting part on an opposite side thereof from the sheet to the outside of the plastic part.

2. The device module according to claim 1, wherein
the connecting part (500) has flexibility, and
the reinforcing part (600) is engaged with or fixed to the connecting part.

3. The device module according to claim 1 or 2, wherein
the device (400) is provided on the sheet (100).

4. The device module according to claim 1 or 2, wherein
the device (400) embedded in the plastic part (300) is in spaced relation to the sheet (100).

5. The device module according to claim 1 or 2, further comprising a spacer (700), wherein
the spacer and the device (400) are embedded in the plastic part (300), with the spacer disposed on the sheet (100) and the device disposed on the spacer.

6. The device module according to claim 5, wherein
all edges (710, 720, 730) of the spacer (700) on the side of the sheet (100) are in curved form.

7. The device module according to claim 5, wherein
the spacer (700) is made of material in a same group as that of the material for the sheet (100) or made of an elastic material.

8. The device module according to any of claims 1 to 4, further comprising a shield (800) provided at a boundary on the reinforcing part (600) between the plastic part (300) and the first opening (320).

9. The device module according to any of claims 1 to 4, wherein
the plastic part (300) further includes a second opening (330) provided on an opposite side of the device (400) from the sheet (100).

10. The device module according to any of claims 5 to 7, wherein
the plastic part (300) further includes a second opening (330) provided on an opposite side of the device (400) from the spacer (700).

11. The device module according to any of claims 1 to 10, wherein
at least one of the sheet (100) and the plastic part (300) has translucency.

12. The device module according to any of claims 1 to 11, wherein
all edges of the reinforcing part (600) on the side of the sheet (100) are in curved form.

13. The device module according to any of claims 5 to 7, wherein
the reinforcing part (600) and the spacer (700) are integrated with each other.

14. The device module according to any of claims 1 to 13, wherein
the connecting part (500) includes an external connecting portion (530) provided on a portion of the connecting part that is exposed from the first opening (320).

15. The device module according to any of claims 1 to 14, wherein
the sheet (100) has translucency, and
the device module further includes an ornamental layer (200) interposed between the sheet and the plastic part (300).
